Europäisches Patentamt

European Patent Office

Office européen des brevets

(19)

(11) Veröffentlichungsnummer: **0 166 328**
**B1**

(12) **EUROPÄISCHE PATENTSCHRIFT**

(45) Veröffentlichungstag der Patentschrift: **09.01.91**

(21) Anmeldenummer: **85107385.8**

(22) Anmeldetag: **14.06.85**

(51) Int. Cl.⁵: **H 01 J 37/26,** H 01 J 37/04, H 01 J 37/05

(54) Verfahren und Anordnung zur elektronenenergiegefilterten Abbildung eines Objektes oder eines Objektbeugungsdiagrammes mit einem Transmissions-Elektronenmikroskop.

(30) Priorität: **22.06.84 DE 3423149**

(43) Veröffentlichungstag der Anmeldung:
**02.01.86 Patentblatt 86/01**

(45) Bekanntmachung des Hinweises auf die Patenterteilung:
**09.01.91 Patentblatt 91/02**

(84) Benannte Vertragsstaaten:
**DE FR GB NL**

(56) Entgegenhaltungen:
FR-A-1 111 567
US-A-3 624 393

JOURNAL OF PHYSICS E; SCIENTIFIC INTRUMENTS, Band 8, Nr. 212, Dezember 1975, Seiten 1033-1037; R.F. EGERTON et al.: "Modification of a transmission electron microscope to give energy-filtered images and diffraction patterns, and electron energy loss spectra"

(73) Patentinhaber: **Firma Carl Zeiss**
**D-7920 Heidenheim (Brenz) (DE)**
(84) **DE FR NL**

(73) Patentinhaber: **CARL-ZEISS-STIFTUNG trading as CARL ZEISS**
**D-7920 Heidenheim (Brenz) (DE)**
(84) **GB**

(72) Erfinder: **Egle, Wilhelm, Dipl.-Phys.**
**Heulenbergweg 30**
**D-7080 Aalen (DE)**
Erfinder: **Ottensmeyer, F. Peter, Prof. Dr.**
**27 Chatfield Drive**
**Don Mills Ontario M3B 1K6 (CA)**
Erfinder: **Rilk, Albrecht, Dipl.-Ing. (FH)**
**Schlehenweg 12**
**D-7923 Königsbronn (DE)**

(56) Entgegenhaltungen:
NOUVELLE REVUE D'OPTIQUE APPLIQUEE, Band 1, Nr. 4, 1970, Juli/August 1970, Seiten 221-228; P. DUVAL et al.: "Réalisation d'un dispositif de filtrage en énergie des images de microdiffraction électronique"

EP 0 166 328 B1

64 Entgegenhaltungen:
JOURNAL OF ULTRASTRUCTURE RESEARCH,
Band 72, 1980, Seiten 336-348, Academic Press,
Inc.; F.P. OTTENSMEYER et al.: "High-resolution
microanalysis of biological specimens by
electron energy loss spectroscopy and by
electron spectroscopic imaging"

NINTH INTERNATIONAL CONGRESS ON
ELECTRON MICROSCOPY, Band 1, 1978, Seiten
40,41, Toronto, CA; J.W. ANDREW et al.: "An
improved magnetic prism design for a
transmission electron microscope energy filter"

## Beschreibung

Die vorliegende Erfindung betrifft ein Verfahren zur elektronenenergiegefilterten Abbildung eines Objektes mit einem Transmissions-Elektronenmikroskop, bei dem die von einer Elektronenquelle ausgehenden Elektronenstrahlen das Objekt beleuchten, das Objekt von einer ersten Abbildungsstufe in die Eingangsbildebene eines abbildenden Elektronenenergie-Spektrometers abgebildet wird, und gleichzeitig die Elektronenquelle in den Eingangscrossoverpunkt des Spektrometers abgebildet wird, bei dem ferner in dem Spektrometer Elektronen eines wählbaren Energiebereiches ausgefiltert werden und das gefilterte Objektbild aus der Ausgangsbildebene des Spektrometers in die Endbildebene abgebildet wird. Die vorliegende Erfindung betrifft ferner ein entsprechendes Verfahren für Objektbeugungsdiagramme.

Ein wesentlicher Vorteil eines Transmissions-Elektronenmikroskopes mit einem abbildenden Elektronenenergie-Spektrometer besteht darin, daß der Kontrast der Objektabbildung durch die Auswahl von Elektronen eines bestimmten Energiebereiches wesentlich besser ist als bei konventionellen Geräten. Das ist am deutlichsten erkennbar bei nicht kontrastierten, sehr dünnen Präparaten mit einem gewählten Energieverlust ($\Delta E$) im Bereich von ca. 100 bis 200 eV. Aber auch ein Objektbild, das durch rein elastisch gestreute Elektronen (Energieverlust $\Delta E=0$) entsteht, indem alle inelastisch gestreuten Elektronen ($\Delta E>0$) ausgeblendet werden, ist im Kontrast gegenüber dem ungefilterten Bild deutlich verbessert.

Ein weiterer wesentlicher Vorteil eines Transmissions-Elektronenmikroskopes mit einem abbildenden Elektronenenergie-Spektrometer besteht in der Möglichkeit element-spezifische Objektabbildungen, d.h. Element-Verteilungsbilder, gleichzeitig von einem relativ großen Objektbereich dadurch durchzuführen, daß der vom Elektronenenergie-Spektrometer durchgelassene Energiebereich einer element-spezifischen Wechselwirkung der transmittierten Elektronen mit dem Objekt entspricht, also z.B. einer K-, L-, M-Absorption in der Atomhülle. Damit können qualitative und bei Messung der Intensitätsverhältnisse und Abzug des Untergrundes auch quantitative Verteilungsbilder von Elementen in dünnen Objekten (30 nm) mit sehr hoher Ortsauflösung ($\approx 0,5$ nm) und höchster Nachweisempfindlichkeit ($\approx 2.10^{-21}$g) gewonnen werden, die bisher mit keiner anderen Analysentechnik erreicht wurden. Höchste Ortsauflösung und Nachweisempfindlichkeit von Elementen sind sowohl für die biologische und medizinische Forschung als auch für die Material-Wissenschaft von großer Bedeutung.

Auch bei Elektronenbeugungsdiagrammen bewirkt ein abbildendes Elektronenenergie-Spektrometer durch die Ausblendung von inelastisch gestreuten Elektronen schärfere Bilder des Beugungsdiagrammes. Aus der US—A—3.624.393. (DE—A—20 28 357) ist einen Elektronenmikroskop bekannt, das nicht nur eine Filterung des Objektbildes sondern auch des Beugungsdiagrammbildes ermöglicht. Hierfür wird von einer ersten Abbildungsstufe aus drei Linsen in der Eingangsbildebene des Spektrometers (in der PS mit B2 bezeichnet) ein vergrößertes Bild des Beugungsdiagrammes und in der Eingangscrossoverebene (in der PS mit B1 bezeichnet) ein Objektbild erzeugt. Die Nachteile dieser bekannten Vorrichtung sind, daß für das gefilterte Beugungsdiagramm nur eine Vergrößerung möglich ist und daß für gefilterte Objektbilder nur eine geringe Vergrößerungsvariation möglich ist, die in der PS nicht angegeben ist, und bei der die Erregung der Objektivlinse zur Scharfeinstellung des Bildes nachgestellt werden muß.

Aus einer Veröffentlichung von Egerton e.a. (J. o. Physics E, Scient. Instrum. *8*, 1033 (1975)) ist ein weiteres Elektronenmikroskop mit Elektronenenergie-Spektrometer für Objekt- und Beugungsdiagrammbilder bekannt, bei dem zwischen Objekt und Spektrometer zwei Linsen angeordnet sind. Für Objektbilder ist eine Vergrößerungsvariation zwischen 5000 und 50 000 durch Veränderung des Erregungsstromes der nach dem Spektrometer angeordneten Projektionslinsen vorgesehen.

Aus der Literatur sind einige weitere Kombinationen von Transmissions-Elektronenmikroskopen mit abbildenden Elektronenenergie-Spektrometern bekannt, von denen die Veröffentlichung von F. P. Ottensmeyer und J. W. Andrew, J. o. Ultrastructure Research *72*, 336 (1980) der hier beschriebenen Erfindung am nächsten kommt. Dort ist ein Elektronenmikroskop angegeben, bei dem zwischen Objektiv mit 1. und 2. Zwischenlinse und Projektiv-Linse ein abbildendes Spektrometer angeordnet ist, welches aus einer Eingangslinse, dem eigentlichen Prisma-Spiegel-Prisma-Spektrometer (Castaing-Typ) und einer Ausgangslinse besteht. Diese Anordnung hat von allen bekannten Anordnungen die flexibelste Abbildungsoptik. Die Vergrößerungsänderung findet im wesentlichen durch Änderung der Erregung an den beiden Zwischenlinsen statt. Dabei verlagert sich jedoch die Bildlage und das Bild der Elektronenquelle (Crossover) vor dem Spektrometer. Durch entsprechende Erregung der Eingangslinse des Spektrometers muß der Crossover an die richtige Stelle für das eigentliche Spektrometer gelegt werden; die Bildlage wird durch Nachfokussierung der Objektivlinse korrigiert. Das gleiche Vorgehen ist erforderlich wenn die hintere Brennebene des Objektives für die Abbildung eines Elektronenbeugungsdiagrammes durch Änderung der Erregung von 1. und 2. Zwischenlinse in das Spektrometer abgebildet wird. Die Begrenzung der Abbildungsapertur des Spektrometers erfolgt durch eine Bereichsblende im 1. Zwischenbild nach der Objektivlinse.

Diese bekannte Kombination von Elektronenmikroskop und Elektronenenergie-Spektrometer hat folgende Nachteile:

1. Der Vergrößerungsbereich ist auf mittlere und hohe Vergrößerungen (>300 x) begrenzt; er ist um den Faktor 2 gegenüber dem ursprünglichen Elektronenmikroskop nach oben verschoben. Die mögliche Vergrößerungsvariation beträgt ca. 150:1.

2. Für jede Vergrößerungsstufe muß in Iterationsschritten zuerst die Eingangslinse des Spektrometers zur Erhaltung der Lage des Crossovers eingestellt werden, dann die Objektivlinse zur Bildscharfstellung nachfokussiert werden usw. Daher ist ein Vergrößerungswechsel sehr zeitraubend und führt somit bei strahlungsempfindlichen Objektiven zu irreparablen Strahlenschäden.

3. Die für das Spektrometer wirksame Apertur, d.h. das Bild der Bereichsblende in der Eingangsbildebene, ändert sich beim Vergrößerungswechsel. Daher muß für jede Vergrößerungsstufe eine entsprechende Bereichsblende gewählt werden, um eine optimale Anpassung an das gewünschte Bildformat (Fotoformat) zu erhalten. Das ist bei der großen notwendigen Anzahl von Vergrößerungsstufen praktisch unmöglich.

4. Das abbildende Elektronenenergie-Spectrometer vom Prisma-Spiegel-Prisma-Typ (Castaing-Typ) hat deutliche Aberrationen, welche das Energie-Auflösungsvermögen begrenzen. Aus einer Veröffentlichung von J. W. Andrew, F. P. Ottensmeyer und E. Martell, Ninth international Congress on Elektron Microscopy, Toronto, *1*, 40 (1978) ist zwar bekannt, daß durch gekrümmte Ein- und Austrittsflächen der Prismen eine deutliche Verminderung der Aberrationen gegenüber ebenen Ein- und Austrittsflächen möglich ist; es fehlen jedoch Angaben über vorteilhafte Ausführungsformen dieser Flächen.

Der vorliegenden Erfindung liegt daher die Aufgabe zugrunde, bei einem Transmissions-Elektronenmikroskop mit abbildenden Elektronenenergie-Spektrometer einen möglichst großen Vergrößerungsbereich zu erreichen, ohne daß beim Vergrößerungswechsel Nachstellungen (Nachfokussierung) notwendig sind. Außerdem soll eine vergrößerungsunabhängige Spektrometer-Aperturblende zur Wahl der Energieauflösung bei optimaler Anpassung an die bildbegrenzende Fläche des jeweiligen Detektors geschaffen werden. Mit demselben Transmissions-Elektronenmikroskop soll auch die Abbildung energiegefilterter Beugungsdiagramme mit einer Vergrößerungsvariation von mindestens 3:1 möglich sein. Die Erfindung hat ferner die Aufgabe, die Energieauflösung des Elektronenenergie-Spektrometers mit Prisma-Spiegel-Prisma-System zu verbessern.

Die vorliegende Aufgabe wird für Objektbilder mit einem Bereich der Gesamtvergrößerung von ca. 300× bis 250 000× durch die Merkmale im kennzeichnenden Teil des Anspruches 1 und für einen Bereich der Gesamtvergrößerung von ca. 100× bis 2000× durch den kennzeichnenden Teil des unabhängigen Anspruches 2 gelöst.

Für Beugungsdiagrammbilder wird die Aufgabe durch die Merkmale im kennzeichnenden Teil des unabhängigen Anspruches 3 gelöst.

In einer vorteilhaften Ausführungsform der Erfindung wird mit der zweiten Abbildungsstufe die Ausgangsbildebene des Spektrometers mit einer konstanten Vergrößerung in die Endbildebene abgebildet, wobei die konstante Vergrößerung lediglich der bildbegrenzenden Fläche des jeweiligen Detektors angepaßt wird.

Bei einem Transmissions-Elektronenmikroskop zur Durchführung des erfindungsgemäßen Verfahrens ist die erste Abbildungsstufe aus vier elektronenoptischen Linsengruppen aufgebaut, die mit einer Stromversorgungseinheit verbunden sind, in welcher für jede Vergrößerungsstufe und für jede Linse der erforderliche Erregungsstrom festgelegt ist. Jede Linsengruppe kann aus einer oder mehreren elektronenoptischen Linsen bestehen. Die Spektrometer-Aperturblende ist zwischen dem Eingangscrossover und der Eingangsbildebene des Spektrometers möglichst dicht vor der Eingangsbildebene angeordnet und hat zur Wahl der Spektrometer-Apertur bzw. der Energieauflösung wechselbare kreisförmige Öffnungen.

Weitere Ausgestaltungen der Erfindung gehen aus den Unteransprüchen hervor.

Die Erfindung wird im folgenden anhand eines in den Figuren 1 bis 5 dargestellten Ausführungsbeispiels näher erläutert. Dabei zeigen:

Fig. 1 den prinzipiellen Aufbau eines zur Ausübung des Verfahrens dienenden Transmissions-Elektronenmikroskopes;

Fig. 2 eine schematische Darstellung der Ein- und Ausgangsparameter eines Elektronenenergie-Spektrometers mit Prisma-Spiegel-Prisma-System;

Fig. 3a—3d Strahlengänge der ersten Abbildungsstufe für verschiedene Vergrößerungsbereiche bei Objektabbildung und für die Abbildung von Objektbeugungsdiagrammen;

Fig. 4 eine schematische Darstellung des Aufbaus der ersten Abbildungsstufe und des Elektronenenergie-Spektrometers einschließlich Apertur- und Spaltblende und

Fig. 5 eine Skizze zur Kennzeichnung der kreisförmig ausgebildeten Ein- und Austrittsflächen des Spektrometerprismas.

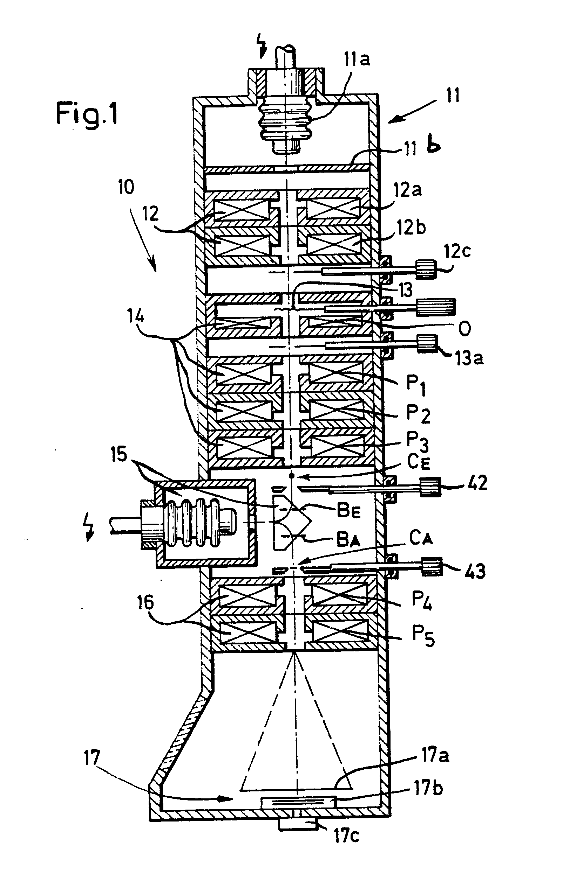

In Figur 1 ist mit 10 ein Transmissions-Elektronenmikroskop bezeichnet, dessen Elektronenquelle 11 aus einer Kathode 11a und einer Beschleunigungselektrode 11b besteht. Die Linsen 12a und 12b bilden das Kondensorsystem; 12c ist eine Kondensorblende. Das abzubildende Objekt 13 ist auswechselbar innerhalb der Objektivlinse O angeordnet und wird durch diese in eine Zwischenbildebene $B_1$, z.B. bei mittleren bis hohen Vergrößerungen in die Bereichsblende 13a vergrößert abgebildet. Von dort wird das Zwischenbild durch die weiteren Linsen $P_1$, $P_2$, $P_3$ der ersten Abbildungsstufe 14 in das abbildende Elektronenenergie-Spektrometer 15 abgebildet, vor dem die Aperturblende 42 angeordnet ist. Am Ausgang des 1:1 abbildenden Spektrometers 15 befindet sich die Spaltblende 43, mit welcher ein wählbarer Energiebereich ausgeblendet wird. Die nachfolgende zweite Abbildungsstufe 16 bildet das Ausgangsbild des Spektrometers 15 in die Endbildebene 17 ab. Dort ist normalerweise ein Leuchtschirm 17a, eine Kamera mit Filmen 17b oder gegebenenfalls ein elektronischer Detektor 17c angeordnet.

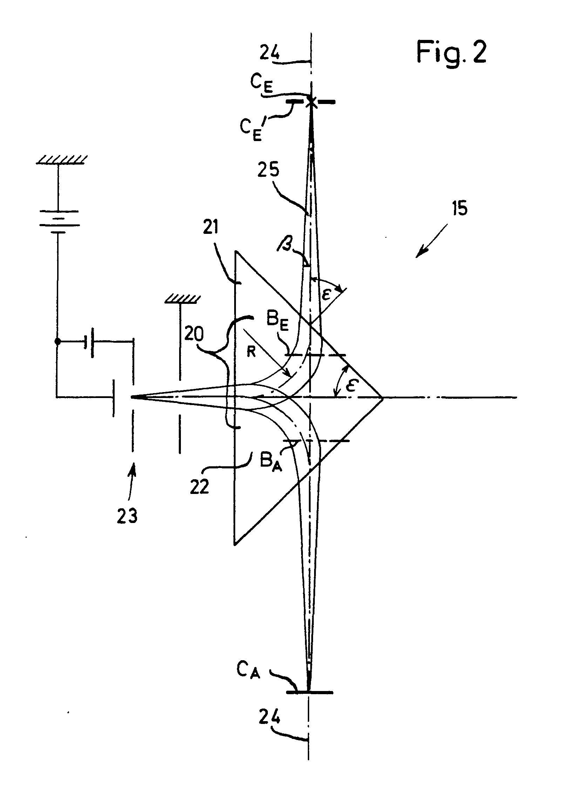

Für eine genauere Beschreibung der Abbildungsverhältnisse ist es zweckmäßig, erst die elektronenoptischen Eigenschaften des bekannten Spektrometer 15 zu beschreiben. Der prinzipielle Aufbau eines Prisma-Spiegel-Prisma-Systems (Castaing-Typ) ist in Figur 2 dargestellt. Das Spektrometer 15 besteht aus einem magnetischen Prisma 20, welches durch einen Magneten mit zwei Pohlschuhen erzeugt wird, deren Abschlußflächen die Form des Prismas 20 haben und dicht unter- und oberhalb der Zeichenebene liegen. Es hat zwei spiegelsymmetrische Wirkungsbereiche 21 und 22 und einen elektrostatischen Spiegel 23. Der in der optischen Achse 24 mit dem Aperturwinkel ß einfallende Elektronenstrahl 25 wird durch den oberen Wirkungsbereich 21 um ca. 90° zum Spiegel 23 abgelenkt, an dem er reflektiert wird. Anschließend wird der Elektronenstrahl 25 im unteren Wirkungsbereich 22 wieder um ca. 90° abgelenkt und verläßt das Spektrometer in Richtung der optischen Achse 24. Der exakte Ablenkwinkel hängt jeweils von der Energie der Elektronen ab, so daß in der Dispersionsebene $C_A$ ein Spektrum der Energie der vom Objekt transmittierten Elektronen entsteht, von dem ein Teil durch Spaltbacken 43b, 43c ausgeblendet werden kann. Das Spektrometer 15 bildet die Eingangsbildebene $B_E$ in die Ausgangsbildebene $B_A$ im Maßstab 1:1 und den Eingangscrossoverpunkt $C_E$ in die Dispersionsebene $C_A$ ab. Für eine einwandfreie Funktion des Spektrometers in einem Elektronenmikroskop ist es notwendig, daß durch die vor dem Spektrometer angeordneten elektronenoptischen Linsen das Bild der Strahlquelle 11 in den Eingangscrossoverpunkt $C_E$ und das Bild des Objektes 13 in die Eingangsbildebene $B_E$ abgebildet wird—bzw. daß bei Objektbeugungsdiagrammen das Bild der Strahlquelle 11 in die Eingangsbildebene $B_E$ und das Objektbild in die Eingangscrossoverebene $C_E'$ abgebildet wird. Nur wenn diese Bedingungen exakt erfüllt sind, erfolgt durch das Spektrometer eine acharomatische Abbildung und eine optimale Energiefilterung.

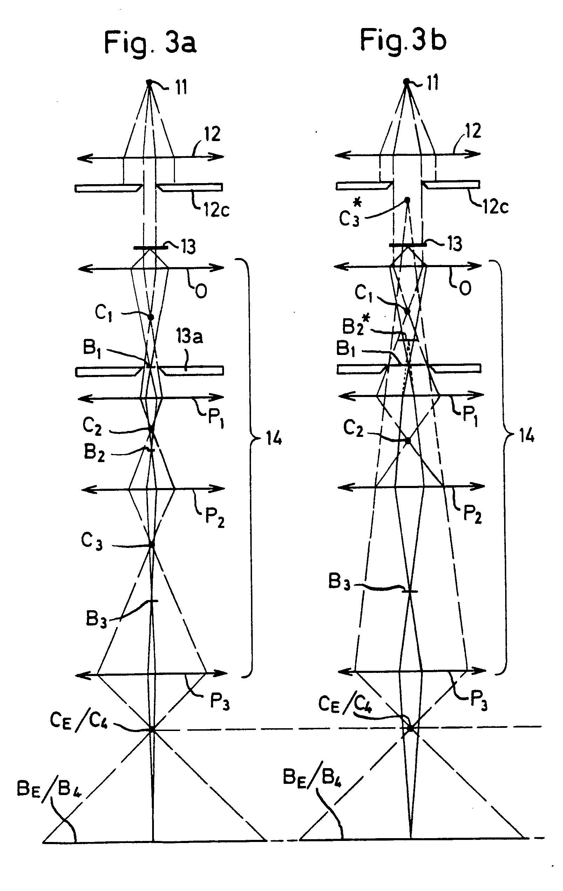

Um diese Bedingungen für einen möglichst großen Vergrößerungsbereich zu erfüllen, ist erfindungsgemäß die erste Abbildungsstufe 14 aus vier elektronenoptischen Linsengruppen O, $P_1$, $P_2$, $P_3$ ausgebaut, wobei jede Linsengruppe aus einer oder mehreren Linsen bestehen kann und wobei durch unterschiedliche Erregungen der elektromagnetischen Spulen der Linsengruppen O, $P_1$, $P_2$, $P_3$ die Umschaltung auf unterschiedliche Vergrößerungen und von Objektabbildung auf Beugungsabbildung und umgekehrt erfolgt. Die bei verschiedenen Vergrößerungsbereichen für Objektabbildung und bei Beugungsabbildung vorliegenden Abbildungs- und Beleuchtungsstrahlengänge sind in den Figuren 3a bis 3d dargestellt.

Figur 3a zeigt gestrichelt den Beleuchtungsstrahlengang und ausgezeogen den Abbildungsstrahlengang für einen Objektpunkt auf der optischen Achse für eine Gesamtvergrößerung von ca. 25.000× bis 250.000×, bzw. für eine Vergrößerung durch die erste Abbildungsstufe 14 von ca. 300× bis 3.000×. Durch das Kondensorsystem 12 wird das Objekt 13 mit einem annähernd parallelen Elektronenstrahl beleuchtet, dessen Durchmesser durch die Kondensorblende 12c bestimmt ist. Die erste Linsengruppe O erzeugt vom Objekt 13 ein reelles Zwischenbild $B_1$ und von der Elektronenquelle 11 das reelle Zwischenbild (Crossover) $C_1$. Das zweite Linsensystem $P_1$ erzeugt das reelle Zwischenbild $B_2$ und den reellen Crossover $C_2$; das dritte Linsensystem $P_2$ erzeugt das reelle Zwischenbild $B_3$ und den reellen Crossover $C_3$. Schließlich erzeugt das Linsensystem $P_3$ in der Eingangsebene $B_E$ des Spektrometers 15 das reelle Zwischenbild $B_4$ des Objektes 13 und im Eingangscrossoverpunkt $C_E$ des Spektrometers 15 den reellen Crossover $C_4$. Dieser Abbildungs- und Beleuchtungsstrahlengang weicht von bekannten Strahlengängen dadurch ab, daß diese bis zu einem Zwischenbild vor der letzten Abbildungsstufe eine geringere Anzahl von Linsen bzw. Linsensystemen enthalten und daß ihr letzter Crossoverpunkt vor dem Zwischenbild keine definierte, konstante Lage hat. Entscheidend ist, daß mit derselben ersten Abbildungsstufe 14, bestehend aus den Linsengruppen O, $P_1$, $P_2$, $P_3$ auch die in den Figuren 3b bis 3d dargestellten Strahlengänge erzeugt werden.

In Figur 3b ist gestrichelt der Beleuchtungsstrahlengang und ausgezogen der Abbildungsstrahlengang für eine Gesamtvergrößerung von 2.500× bis 25.000×, bzw. für eine Vergrößerung durch die erste Abbildungsstufe 14 von ca. 30× bis 300× dargestellt. Die Beleuchtung des Objektes 13 erfolgt entsprechend der Figur 3a und die erste Linsengruppe O erzeugt wieder ein reelles Zwischenbild $B_1$ des Objektes 13 und einen reellen Crossover $C_1$. Die zweite Linsengruppe $P_1$ wird jedoch in diesem Fall so schwach erregt, daß sie zwar einen reellen Crossover $C_2$ erzeugt aber nur ein virtuelles Zwischenbild $B_2^*$ des Objektes 13. Durch die dritte Linsengruppe $P_2$ wird dann ein reelles Zwischenbild $B_3$ des Objektes 13, aber nur ein virtueller Crossover $C_3^*$ erzeugt. Die vierte Linsengruppe $P_3$ erzeugt schließlich ein reelles Zwischenbild $B_4$ des Objektes 13 in der Eingangsbildebene $B_E$ des Spektrometers 15 und einen reellen Crossover $C_4$ im Eingangscrossoverpunkt $C_E$ des Spektrometers 15. Auch der in Figur 3b dargestellte Abbildungs- und Beleuchtungsstrahlengang unterscheidet sich von bekannten Strahlengängen dadurch, daß diese bis zu einem Zwischenbild vor der letzten Abbildungsstufe eine geringere Anzahl von Linsen bzw. Linsensystemen enthalten und daß ihr letzter Crossoverpunkt vor dem Zwischenbild keine definierte, konstante Lage hat.

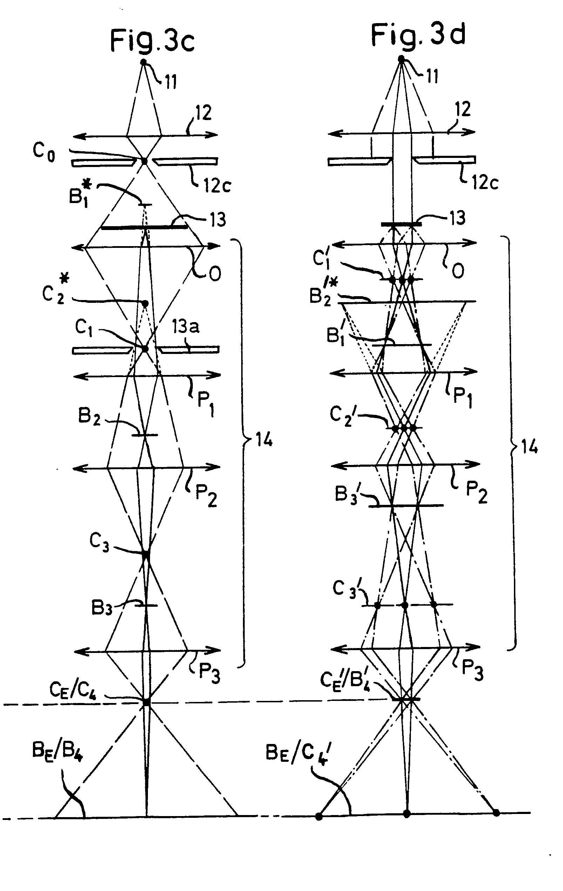

Figur 3c zeigt gestrichelt den Beleuchtungsstrahlengang und ausgezogen den Abbildungsstrahlengang für eine Gesamtvergrößerung von ca. 100× bis 2.000×, bzw. für eine Vergrößerung der ersten Abbildungsstufe 14 von ca. 1,2× bis 24×. In diesem Fall entsprechen die Strahlen-

gänge bis zum Zwischenbild $B_2$ der DE—A—27 42 264. Die Kondensorlinse wird—im Gegensatz zu den in den Figuren 3a und 3b vorliegenden Vorhältnissen—so erregt, daß ein mit $C_o$ bezeichnetes Zwischenbild (Crossover) der Strahlquelle bereits vor dem Objekt 13 liegt, und zwar in oder in der Nähe der Kondensorblende 12c. Die erste Linsengruppe O wird so schwach erregt, daß der nächste Crossover $C_1$ in der Bereichsblende 13a liegt und vom Objekt 13 nur ein virtuelles Bild $B_1^*$ entsteht. Die zweite Linsengruppe $P_1$ erzeugt ein reelles Zwischenbild $B_2$ des Objektes 13 und einen virtuellen Crossover $C_2^*$. Durch die dritte Linsengruppe $P_2$ werden ein reelles Zwischenbild $B_3$ und ein reeller Crossover $C_3$ erzeugt und durch die vierte Linsengruppe $P_3$ werden ein reelles Zwischenbild $B_4$ des Objektes 13 in der Eingangsbildebene $B_E$ des Spektrometers 15 und ein reeller Crossover $C_4$ im Crossovereingangspunkt $C_E$ des Spektrometers erzeugt.

In Figur 3d sind die Strahlengänge für die Abbildung von Elektronenbeugungsdiagrammen dargestellt. Die Beleuchtung der Probe 13 erfolgt wieder entsprechend den Figuren 3a und 3b. Die Linsengruppe O erzeugt von den an der Probe 13 gestreuten Elektronen das Objektbeugungsdiagramm $C_1'$ und das Objektbild $B_1'$. Den vom Objekt 13 nicht gestreuten Elektronen entspricht der ausgezogene Strahlengang und den vom Objekt 13 gestreuten Elektronen entsprechen die strichpunktierten Strahlengänge. Die zweite Linsengruppe $P_1$ erzeugt vom Objektbeugungsdiagramm $C_1'$ das Beugungszwischenbild $C_2'$ und vom Objektbild $B_1'$ das virtuelle Zwischenbild $B_2'^*$. Durch die dritte Linsengruppe $P_2$ wird dann ein reelles Beugungszwischenbild $C_3'$ und ein reelles Objektzwischenbild $B_3'$ erzeugt, welche durch die vierte Linsengruppe $P_3$ in die Eingangsbildebene $B_E$ und die Eingangscrossoverebene $C_E'$ des Spektrometers abgebildet werden.

Für jeden der in den Figuren 3a bis 3d dargestellten Strahlenverläufe sind mehrere Vergrößerungsstufen möglich. Ihre Zahl ist lediglich eine Frage des Aufwandes und des Nutzens. Entscheidend ist daß mit den in den Figuren 3a und 3b dargestellten Strahlengängen für Objektbilder eine Vergrößerungsvariation von ca. 100:1 mit jeder gewünschten Abstufung bei definierter und konstanter Lage des Zwischenbildes $B_4$ und des Crossoverpunktes $C_4$ möglich ist. Dieser Vergrößerungsvariation wird durch die in Figur 3c beschriebenen Strahlengänge auf ca. 2.500:1 erweitert. Die mit Figur 3d dargestellten Strahlengänge erlauben für Begungsdiagramme eine Vergrößerungsvariation von 20:1 mit derselben ersten Abbildungsstufe 14. In allen Fällen wird dabei erreicht, daß nach einmaliger Scharfeinstellung auf das Objekt 13 bzw. auf das Beugungsdiagramm, die selbstverständlich bei der jeweils stärksten Vergrößerung durchgeführt wird, bei beliebigen Wechsel zwischen den Vergrößerungsstufen keine Nachstellung bzw. Nachfokussierung notwendig ist. Jede der mit O, $P_1$, $P_2$ und $P_3$ bezeichneten Linsengruppen kann aus einer oder mehreren Linsen bestehen.

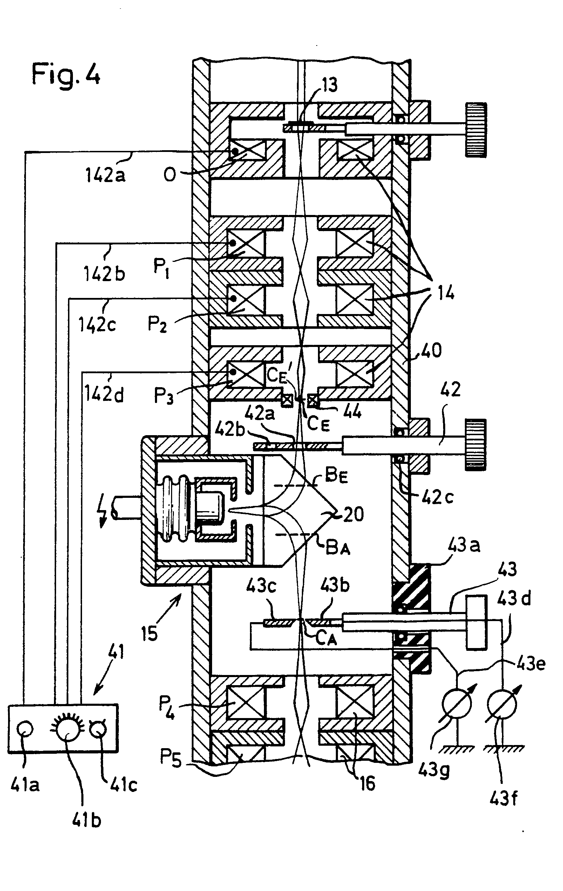

Die Einstellung der verschiedenen Vergrößerungsstufen erfolgt über die in Figur 4 mit 41 bezeichnete Steuereinheit. Diese ist über Kabel 42a bis 42d mit den Spulen der Linsen O, $P_1$, $P_2$, $P_3$ verbunden, welche die Linsen mit den für die Vergrößerungsstufen notwenidgen Erregungsströmen versorgen. Hierfür hat die Steuereinheit 41 einen Vergrößerungsstufenschalter 41b, mit dem bei jeder Vergrößerungsstufe für jede Linse mittels einer Analog-Steuerung, z.B. durch Umschaltung von Sollwert-Widerständen, die Linsenerregungsströme erzeugt werden. Selbstverständlich ist dies auch mit modernen technologischen Mitteln möglich, z.B. mit einer digitalen Steuerelektronik, bei der die Sollwerte in einem elektronischen Festwertspeicher (E-PROM) gespeichert sind und über einen Digital-Analog-Wandler in die Linsenerregungsströme umgewandelt werden. Am Steuergerät 41 ist außerdem ein Schalter 41c zum Umschalten von Objektabbildung auf Beugungsabbildung und umgekehrt und ein Abgleichregler 41a zum Scharfeinstellen (Fokussieren) des Objektes vorhanden.

Figur 4 zeigt ferner schematisch den Aufbau der Aperturblende 42 für das Spektrometer 15. Diese Aperturblende 42 sollte im Idealfall in der Eingangsbildebene $B_E$ des Spektrometers sitzen. Da dies wegen des sehr geringen Abstandes der Polschuhe des Prismas 20 aus mechanischen Gründen kaum möglich ist, ist die Aperturblende 42 möglichst dicht vor dem Prisma 20 angeordnet, was in der Praxis ausreichend ist, weil in Folge der geringen Ausdehnung des Bildes der Elektronenquelle im Eingangscrossoverpunkt $C_E$ immer eine scharf begrenzte Schattenabbildung der Aperturblende 42 in die Eingangsbildebene $B_E$ erfolgt. Die Eingangsaperturblende 42 besteht aus einer vakuumdichten Durchführung 42c durch die Mikroskopsäule 40 und kreisförmigen Blenden 42a, 42b mit unterschiedlichen Durchmessern, welche wahlweise in den Strahlengang gebracht werden können.

Da die Vergrößerungseinstellung durch die erste Abbildungsstufe 14 vor der Spektrometer-Aperturblende 42 erfolgt und mit der zweiten Abbildungsstufe 16 nach dem Spektrometer 15 nur noch eine konstante Vergrößerung erfolgt, die lediglich der bildbegrenzenden Fläche des Detektors 17a, 17b, 17c angepaßt wird, ist die Wirkung der Aperturblende 42 vergrößerungsunabhängig. Die kreisförmigen Blenden 42a, 42b mit unterschiedlichen Durchmessern ermöglichen die Einstellung verschiedener Aperturwinkel ß. Trotz der weiter unten beschriebenen wesentlichen Verbesserung der Abbildungseigenschaften des Spektrometers 15 durch kreisförmige Ein- und Austrittsflächen 51, 52, 53 ist die Energieauflösung des Spektrometers in der Dispersionsebene $C_A$ immer noch aperturabhängig. Die Einstellmöglichkeit verscheidener Aperturwinkel ermöglicht daher eine Veränderung der Energieauflösung des Spektrometers, so daß diese entweder optimal an die bildbegrenzende Fläche des jeweiligen Detektors 17b, 17c angepaßt werden kann, wobei für ß<10 mrad die Energieauflösung<15 eV ist, oder durch die Wahl einer sehr kleinen (bildbegrenzenden) Blende die Energieauflösung bis zur Energiebreite der Strahlquelle 11 verbessert werden kann, d.h. für eine thermischen Strahlquelle bis zur minimalen Energiebreite von 0,8 eV reduziert werden kann.

In Figur 4 ist außerdem schematisch die Spaltblende 43 dargestellt, welche in der Dispersionsebene $C_A$ des Spektrometers 15 angeordnet ist. Die Spaltblende 43 hat eine vakuumdichte Durchführung durch einen Isolator 43a, welcher in der Mikroskopsäule 40 sitzt. Die beiden Spaltbacken 43b und 43c können gemeinsam und gegeneinander verschoben werden; sie sind gegeneinander isoliert und durch getrennte Leitungen 43d, 43e mit Strommeßgeräten 43f, 43g außerhalb der Mikroskopsäule 40 verbunden. Mit dieser Anordnung kann sowohl ein Teil des Spektrums für die Objektabbildung ausgeblendet als auch der Elektronenstrom von verschiedenen Teilen des Spektrums direkt gemessen werden.

Am unteren Ende der ersten Abbildungsstufe 14 ist in Figur 4 ein Ablenksystem 44 dargestellt, welches in der Eingangscrossoverebene $C_E'$ des Spektrometers 15 angeordnet ist. Mit diesem Ablenksystem 44 kann der aus der ersten Abbildungsstufe 14 austretende Elektronenstrahl genau in die optische Achse 24 (Figur 2) des Spektrometers 15 ausgerichtet werden, ohne daß irgendwelche anderen Abbildungsparameter beeinflußt werden.

Auf das Spektrometer 15 folgt wie in den Figuren 1 und 4 dargestellt, die zweite Abbildungsstufe 16. Sie hat zwei Aufgaben:

a) Die Ausgangsbildebene $B_A$ des Spektrometers 15 wird mit einer konstanten Vergrößerung von ca. 80× in die Endbildebene 17 abgebildet. Dabei wird die konstante Vergrößerung lediglich der bildbegrenzenden Fläche des Detektors angepaßt, also entweder dem Endbildleuchtschirm 17a, dem Format des Filmes 17b für photographische Aufnahmen oder der wirksamen Fläche eines elektronischen Detektors 17c (Figur 1). Bei Verwendung eines elektronischen Detektors 17c, der im allgemeinen, z.B. bei einem Faraday-Käfig, klein gegenüber dem Endbildleuchtschirm ist, kann die Gesamtvergrößerung mit der zweiten Abbildungsstufe 16 aber auch absichtlich so gewählt werden, daß der elektronische Detektor 17c nur einen ausgewählten Teilbereich des gesamten Bildes in der Endbildebene 17 erfaßt. Damit ist z.B. bei einer Gesamtvergrößerung von 250.000× und bei einem Detektordurchmesser von 2,5 mm die Analyse der (chemischen) Elemente eines Objektbereiches von 10 nm Durchmesser möglich, wobei gleichzeitig ein um den Faktor ca. 50 im Durchmesser größerer Bereich auf dem Endbildleuchtschirm 17a beobachtet werden kann und damit sowohl ein leichtes Auffinden interessanter Bereiche als auch eine exakte Zuordnung des Bereiches für eine derartige Mikroanalyse in die Detektorfläche möglich ist. Dadurch werden die sonst bei Punktbeleuchtung, z.B. mit Rastersonden, auftretenden Probleme wie Objektkontamination, Zuordnungsfehler, geringe Sondenströme etc. vermieden. In diesem Fall ist es besonders günstig, das Energiespektrum nicht durch Veränderung der Spaltbacken 43b, 43c, sondern—wie aus der Literatur bekannt (F. P. Ottensmeyer und J. W. Andrew, J. o. Ultrastructure Research *72*, 336 (1980)—durch Ändern der Beschleunigungsspannung der Elektronenquelle 11 aufzunehmen, weil damit ein größerer Energiebereich mit optimalen Abbildungsbedingungen erfaßt werden kann.

b) Die zweite Abbildungsstufe 16 kann auch——wie ebenfalls aus der unter a) angegebenen Literaturstelle bekannt—auf die Dispersionsebene $C_A$ eingestellt werden, dann wird bei aus dem Strahlengang gebrachten Spaltbacken 43b, 43c ein Teilbereich des Spektrums in der Endbildebene 17 abgebildet. Dieses Teilspektrum kann auf einen Film 17b aufgenommen werden. Wenn ein elektronischer Detektor 17c verwendet wird, ist es wieder günstiger, das Energiespektrum durch Ändern der Beschleunigungsspannung der Elektronenquelle 11 aufzunehmen. Falls nicht schon durch die kleine Abmessung des elektronischen Detektors das Energieauflösungsvermögen ausreichend ist, können die Spaltbacken 43b, 43c in den Strahlengang gebracht werden. In diesen Fällen wird im Gegensatz zu a) eine Analyse der (chemischen) Elemente des gesamten ausgeleuchteten Bereiches des Objektes 13 durchgeführt. Dieser hat. z.B. bei einer Gesamtvergrößerung von 250.000× einen Durchmesser von ca. 3 μm.

Die zweite Abbildungsstufe 16 ist aus mindestens zwei Projektiv-Linsen $P_4$, $P_5$ aufgebaut, die unabhängig voneinander in ihrer Linsenstärke verändert werden können. Die erste Linse $P_4$ bildet entweder die Ausgangsbildebene $B_A$ oder die Dispersionsebene $C_A$ in die Gegenstandsebene der zweiten Linse $P_5$ ab. Mit der zweiten Linse $P_5$ erfolgt die optimale Anpassung der Aperturblende oder die Anpassung des Spektrumbereiches an die unterschiedlichen Endbildformate, z.B. auf unterschiedliche Fotoformate verschiedener Kameras oder an die Größe eines Detektorsystems.

Letzteres kann z.B. ein Faraday-Käfig, eine Szintillator-Photovervielfacher-Kombination, ein CCD-Array oder ein Durchsichtleuchtschirm mit nachgeschalter Fernsehaufnahmeröhre sein.

Für eine bevorzugte Ausführungsform der ersten und zweiten Abbildungsstufe sind im folgenden Abstände und Linsenbrennweiten angegeben, wobei für jedes Linsensystem eine elektronenoptischen Linse vorgesehen ist.

Abstand

O−P$_1$=92 mm
P$_1$−P$_2$=57 mm
P$_2$−P$_3$=103 mm
P$_3$−C$_E$=38 mm
P$_3$−B$_E$=110 mm
C$_A$−P$_4$=26 mm
B$_A$−P$_4$=98 mm
P$_4$−P$_5$=54 mm

Brennweite

O=2,6 ... 40 mm
P$_1$=7,5 ... 40 mm
P$_2$=6 ... 80 mm
P$_3$=23 ... 52 mm
P$_4$=18 ... 44 mm
P$_5$=3 ... 6 mm

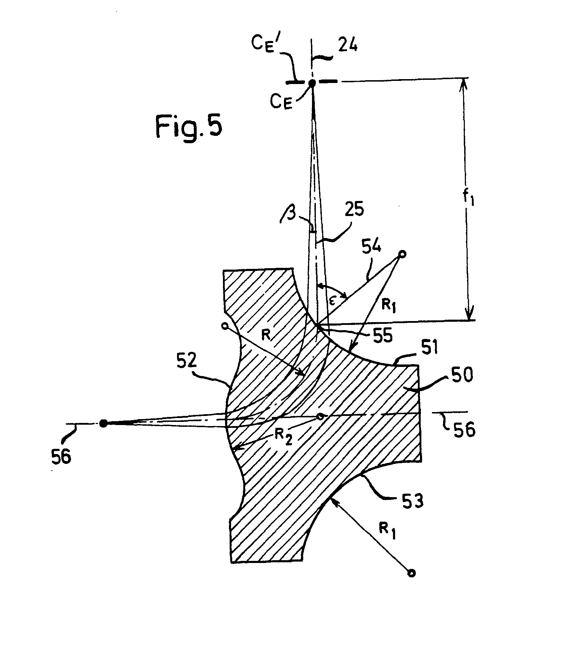

In Figur 5 sind die zur Kennzeichnung einer besonders günstigen Ausbildung eines Prismen-Spiegel-Prismen-Spektrometers notwendigen Parameter dargestellt. Die schaffierte Fläche 50 gibt die Form der Abschlußflächen der Polschuhe des Magneten an, zwischen denen der Elektronenstrahl 25 durchläuft. Mit ε ist der Winkel zwischen der Achse 24 des einfallenden Elektronenstrahles 25 und der Flächennormalen 54 am Eintrittspunkt 55 in das Prisma bezeichnet und mit R der Bahnradius des im Prisma abgelenkten Elektronenstrahles 25. Der Abstand des Eintrittspunktes 55 vom Eingangscrossoverpunkt C$_E$ wird als Brennweite f$_1$ bezeichnet. An Stelle der Dreiecksform des Castaing-Prismas mit ebenen Ein- und Austrittsflächen hat die Eintrittsfläche 51 die Form eines konkaven Kreisausschnittes mit dem Radius R$_1$. Die Austrittsfläche 52 zum Spiegel hat die Form eines konvexen Kreisausschnittes mit dem Radius R$_2$. Diese gekrümmte Fläche 52 ist zugleich die Eintrittsfläche des reflektierten Elektronenstrahls, der durch die Fläche 53 wieder aus dem Prisma austritt. Infolge des symmetrischen Aufbaues zur Achse 56 hat die konkave Austrittsfläche 53 wieder den Krümmungsradius R$_1$. Durch die gekrümmten Ein- und Austrittsflächen 51, 52, 53 werden die Fokussiereigenschaften des Spektrometers sowohl in der Zeichenebene als auch senkrecht dazu wesentlich verbessert, so daß bis zu Aperturen ß von ca. 10 mrad die Aberrationen 2. Ordnung vernachlässigbar sind.

Ein besonders günstiger Dimensionierungsbereich für die Radien R$_1$ und R$_2$ ist im Anspruch 12 angegeben. Kreisförmige Begrenzungen der Polschuhe— und damit der Ein— und Austrittsflächen—haben den Vorteil, daß sie einfach herzustellen sind. Eine weitere Verbesserung der Fokussiereigenschaften ist durch nicht kreisförmig gekrümmte Begrenzungen der Polschuhe möglich.

**Patentansprüche**

1. Verfahren zur elektronenenergiegefilterten Abbildung eines Objektes mit einem Transmissions-Elektronenmikroskop, bei dem die von einer Elektronenquelle ausgehenden Elektronenstrahlen das Objekt beleuchten, das Objekt von einer ersten Abbildungsstufe in die Eingangsbildebene eines abbildenden Elektronenenergie-Spektrometers abgebildet wird, und gleichzeitig die Elektronenquelle in den Eingangscrossoverpunkt des Spektrometers abgebildet wird, bei dem ferner in dem Spektrometer Elektronen eines wählbaren Energiebereiches ausgefiltert werden und das gefilterte Objektbild aus der Ausgangsbildebene des Spektrometers durch eine zweite Abbildungsstufe in die Endbildebene abgebildet wird, dadurch gekennzeichnet, daß die erste Abbildungsstufe (14) vier Zwischenbilder (B$_1$, B$_2$, B$_3$, B$_4$) des Objektes (13) erzeugt, wovon das vierte Zwischenbild (B$_4$) immer in der Eingangsbildebene (B$_E$) des Spektrometers (15) liegt und wobei das zweite Zwischenbild entweder reell (B$_2$) oder virtuell (B$_2$*) ist, während alle anderen Zwischenbilder (B$_1$, B$_3$, B$_4$) immer reell sind, und daß die erste Abbildungsstufe (14) gleichzeitig vier Zwischenbilder (Crossover) (C$_1$, C$_2$, C$_3$, C$_4$) der Elektronenquelle (11) erzeugt, woven der vierte Crossover (C$_4$) immer in dem Eingangscrossoverpunkt (C$_E$) des Spektrometers (15) liegt und wobei der dritte Crossover entweder reell (C$_3$) oder virtuell (C$_3$*) ist, während alle anderen Crossover (C$_1$, C$_2$, C$_4$) immer reell sind.

2. Verfahren zur elektronenenergiegefilterten Abbildung eines Objektes mit einem Transmissions-Elektronenmikroskop, bei dem die von einer Elektronenquelle ausgehenden Elektronenstrahlen das Objekt beleuchten, das Objekt von einer ersten Abbildungsstufe in die Eingangsbildebene eines abbildenden Elektronenenergie-Spektrometers abgebildet wird, und gleichzeitig die Elektronenquelle in den Eingangscrossoverpunkt des Spektrometers abgebildet wird, bei dem ferner in dem Spektrometer Elektronen eines wählbaren Energiebereiches ausgefiltert werden und das gefilterte Objektbild aus der Ausgangsbildebene des Spektrometers durch eine zweite Abbildungsstufe in die Endbildebene abgebildet wird, dadurch gekennzeichnet, daß die erste Abbildungsstufe (14) vier Zwischenbilder (B$_1$*, B$_2$, B$_3$, B$_4$) des Objektes (13) erzeugt, wovon das vierte Zwischenbild (B$_4$) immer in der Eingangsbildebene (B$_E$) des Spektrometers (15) liegt und wobei das erste Zwischenbild (B$_1$*) immer virtuell ist und die zweiten bis vierten Zwischenbilder (B$_2$, B$_3$, B$_4$) immer reell sind, und daß die erste Abbildungsstufe (14) gleichzeitig viert Zwischenbilder (Crossover) (C$_1$, C$_2$, C$_3$, C$_4$) der Elektronenquelle (11) erzeugt, woven der vierte Crossover (C$_4$) immer in dem Eingangscrossoverpunkt (C$_E$) des Spektrometers (15) liegt und wobei der zweite Crossover (C$_2$*) immer virtuell ist, während der dritte und der letzte Crossover (C$_3$, C$_4$) immer reell sind.

3. Verfahren zur elektronenenergiegefilterten Abbildung eines Objektbeugungsdiagrammes mit einem Transmissions-Elektronenmikroskop, bei dem die von einer Elektronenquelle ausgehenden Elektronenstrahlen das Objekt beleuchten, eine erste Abbildungsstufe das Beugungsdiagramm des Objektes erzeugt und in die Eingangsbildebene eines abbildenden Elektronenenergie-Spektrometers abbildet und gleichzeitig das Objekt in die Eingangscrossoverebene des Spektrometers abbildet, bei dem ferner in dem Spektrometer Elektronen eines wählbaren Energiebereiches ausgefiltert werden und das gefilterte Bild des Objektbeugungsdiagrammes aus der Ausgangsbildebene des Spektrometers durch eine zweite Abbildungsstufe in die Endbildebene (17) abgebildet wird, dadurch gekennzeichnet, daß die erste Abbildungsstufe (14) das Beugungsdiagramm (C$_1$') des Objektes (13) und drei Zwischenbilder (C$_2$', C$_3$', C$_4$') des Beugungsdiagrammes erzeugt, wovon das dritte Zwischenbild (C$_4$') immer in der Eingangsbildebene (B$_E$) des Spektrometers (15) liegt, und wobei alle Zwischenbilder reell sind, und daß die erste Abbildungsstufe (14) gleichzeitig vier Zwischenbilder (B$_1$', B$_2$'*, B$_3$', B$_4$') des Objektes erzeugt, wovon das vierte Zwischenbild (B$_4$') immer in der Eingangscrossoverebene (C$_E$') des Spektrometers (15) liegt und wobei das zweite Zwischenbild (B$_2$'*) immer virtuell ist, während alle anderen Zwischenbilder (B$_1$', B$_3$', B$_4$') immer reell sind.

4. Verfahren nach einem der Ansprüche 1 bis 3, dadurch gekennzeichnet, daß mit der zweiten Abbildungsstufe (16) die Ausgangsbildebene (B$_A$) des Spektrometers (15) mit einer konstanten Vergrößerung in die Endbildebene (17) abgebildet wird, wobei die konstante Vergrößerung lediglich der bildbegrenzenden Fläche des jeweiligen Detektors (17a, 17b, 17c) angepaßt wird.

5. Verfahren nach einem der Ansprüche 1 bis 4, dadurch gekennzeichnet, daß die erste Abbildungsstufe (14) aus vier elektronenoptischen Linsengruppen (O, P$_1$, P$_2$, P$_3$) aufgebaut ist, die mit einer Stromversorgungseinheit (41) verbunden sind, in welcher für jede Vergrößerungsstufe und für jede Linse der erforderliche Erregungsstrom festgelegt ist.

6. Verfahren nach Anspruch 5, dadurch gekennzeichnet, daß jede Linsengruppe (O, P$_1$, P$_2$, P$_3$) aus einer oder mehreren elektronenoptischen Linsen aufgebaut ist.

7. Verfahren nach Anspruch 1 oder 6, dadurch gekennzeichnet, daß in der Eingangscrossoverebene (C$_E$') ein Ablenksystem angeordnet ist, durch welches die Richtung des aus der ersten Abbildungsstufe (14) austretenden Elektronenstrahlbündels zur Achse (24) des Spektrometers (15) ausrichtbar ist.

8. Verfahren nach einem der Ansprüche 1 bis 7, dadurch gekennzeichnet, daß zwischen dem Eingangscrossoverpunkt (C$_E$) und der Eingangsbildebene (B$_E$) des Spektrometers (15) eine justierbare Aperturblende (42) mit wechselbaren kreisförmigen Öffnungen (42a, 42b) angeordnet ist.

9. Verfahren nach einem der Ansprüche 1 bis 8, dadurch gekennzeichnet, daß in der Dispersionsebene (C$_A$) des Spektrometers (15) eine in ihrer Breite veränderbare Spaltblende (43) angeordnet ist, die aus zwei zueinander und zum Gehäuse (43a) isolierten Spaltbacken (43b, 43c) aufgebaut ist, zu denen getrennte Meßleitungen (43d, 43e) durch das Gehäuse (43a) geführt sind.

10. Verfahren nach einem der Ansprüche 1 bis 9, dadurch gekennzeichnet, daß das abbildende Elektronenenergie-Spektrometer (15) ein Prisma-Spiegel-Prisma-System ist, dessen Prismen (20) nichtebene Ein- und Austrittsflächen (51, 52, 53) mit konstanten Krümmungsradien R$_1$ und R$_2$ ausgeführt sind, deren Werte in folgenden Bereichen liegen

$$1,0 < R_1/R < 1,35$$

$$0,8 < R_2/R < 1,8$$

wenn für den Winkel ε zwischen der optischen Achse (24) des einfallenden Elektronenstrahles (25) und der Normalen (54) im Eintrittspunkt (55) auf der Eintrittsfläche (51) der Bereich

$$40° < ε < 55°$$

und für den Quotienten aus Eingangsbrennweite des Spektrometers (f$_1$) und dem Radius der Kreisbahnen im Spektrometer (R)

$$f_1/R ≥ 1,8$$

gilt.

**Revendications**

1. Procédé pour la reproduction d'un objet avec filtrate en énergie électronique au moyen d'un microscope électronique à transmission, selon lequel les rayons électroniques issus d'une source d'électrons éclairent l'objet, l'objet est reproduit par un premier étage de reproduction dans le plan d'image d'entrée d'un spectromètre formateur d'image à énergie électronique, et la source d'électrons est simultanément reproduite dans le point de croisement d'entrée du spectromètre, et selon lequel, en outre, des électrons d'un domaine d'énergie pouvant être sélecté sont séparés par filtrage dans le spectromètre et l'image objet filtrée est reproduite à partir du plan d'image de sortie du spectromètre dans le plan d'image finale par un deuxième étage de reproduction, caractérisé en ce que le premier étage de reproduction (14) produit quatre images intermédiaires (B$_1$, B$_2$, B$_3$, B$_4$) de l'objet (13), dont la quatrième image intermédiaire (B$_4$) se trouve toujours dans le plan d'image d'entrée (B$_E$) du spectromètre (15) et la deuxième image intermédiaire est réelle (B$_2$) ou virtuelle (B$_2$*), tandis que toutes les autres images intermédiaires (B$_1$, B$_3$, B$_4$) sont toujours réelles, et que le premier étage de reproduction (14) produit simultanément quatre images intermédiaires (noeuds de faisceau) (C$_1$, C$_2$, C$_3$, C$_4$) de la source d'électrons (11), dont le quatrième noeud (C$_4$) se trouve toujours dans le point de croisement d'entrée (C$_E$) du spectromètre (15) et le troisième noeud est réel (C$_3$) ou virtuel (C$_3$*), tandis que tous les autres noeuds (C$_1$, C$_2$, C$_4$) sont toujours réels.

2. Procédé pour la reproduction d'un objet avec filtrage en énergie électronique au moyen d'un microscope électronique à transmission, selon lequel les rayons électroniques issus d'une source d'électrons éclairent l'objet, l'objet est reproduit par un premier étage de reproduction dans le plan d'image d'entrée d'un spectromètre formateur d'image à énergie électronique, et la source d'électrons est simultanément reproduite dans le point de croisement d'entrée du spectromètre, et selon lequel, en outre, des électrons d'un domaine d'énergie pouvant être sélecté sont séparés par filtrage dans le spectromètre et l'image objet filtrée est reproduite à partir du plan d'image de sortie du spectromètre dans le plan d'image finale par un deuxième étage de reproduction, caractérisé en ce que le premier étage de reproduction (14) produit quatre images intermédiaires ($B_1^*$, $B_2$, $B_3$, $B_4$) de l'objet 13, dont la quatrième image intermédiaire ($B_4$) se trouve toujours dans le plan d'image d'entrée ($B_E$) du spectromètre (15), la première image intermédiaire ($B_1^*$) est toujours virtuelle et les deuxième à quatrième images intermédiaires ($B_2$, $B_3$, $B_4$) sont toujours réelles, et que le premier étage de reproduction (14) produit simultanément quatre images intermédiaires (noeuds de faisceau) ($C_1$, $C_2$, $C_3$, $C_4$) de la source d'électrons (11), dont le quatrième noeud ($C_4$) se trouve toujours dans le point de croisement d'entrée ($C_E$) du spectromètre (15) et le deuxième noeud ($C_2^*$) est toujours virtuel, tandis que le troisième et le dernier noeud ($C_3$, $C_4$) sont toujours réels.

3. Procédé pour la reproduction d'un objet avec filtrage en énergie électronique au moyen d'un microscope électronique à transmission, selon lequel les rayons électroniques issus d'une source d'électrons éclairent l'objet, un premier étage de reproduction génère le diagramme de diffraction de l'objet et en forme l'image dans le plan d'image d'entrée d'un spectromètre formateur d'image à énergie électronique, et reproduit en même temps l'objet dans le plan de croisement d'entrée du spectromètre, selon lequel, en outre, des électrons d'un domaine d'énergie pouvant être sélecté sont séparés par filtrage dans le spectromètre et l'image filtrée du diagramme de diffraction de l'objet est reproduite à partir du plan d'image de sortie du spectromètre dans le plan d'image finale (17) par un deuxième étage de reproduction, caractérisé en ce que le premier étage de reproduction (14) produit le diagramme de diffraction ($C_1'$) de l'objet (13) et trois images intermédiaires ($C_2'$, $C_3'$, $C_4'$) du diagramme de diffraction, dont la troisième image intermédiaire ($C_4'$) se trouve toujours dans le plan d'image d'entrée ($B_E$) du spectromètre (15) et toutes les images intermédiaires sont réelles, et que le premier étage de reproduction (14) produit simultanément quatre images intermédiaires ($B_1'$, $B_2'^*$, $B_3'$, $B_4'$) de l'objet, dont la quatrième image intermédiaire ($B_4'$) se trouve toujours dans le plan de croisement d'entrée ($C_E'$) du spectromètre (15) et la deuxième image intermédiaire ($B_2'^*$) est toujours virtuelle, tandis que toutes les autres images intermédiaires ($B_1'$, $B_3'$, $B_4'$) sont toujours réelles.

4. Procédé selon une des revendications 1 à 3, caractérisé en ce que le deuxième étage de reproduction (16) forme l'image du plan d'image de sortie ($B_A$) du spectromètre (15) avec un grandissement constant dans le plan d'image finale, le grandissement constant étant simplement adapté à la surface de délimitation de l'image du détecteur (17a, 17b, 17c), employé.

5. Procédé selon une des revendications 1 à 4, caractérisé en ce que le premier étage de reproduction (14) est composé de quatre groupes de lentilles optoélectroniques (O, $P_1$, $P_2$, $P_3$) qui sont connectés à une unité d'alimentation électrique (41) dans laquelle est fixé le courant d'excitation nécessaire pour chaque échelon d'agrandissement et pour chaque lentille.

6. Procédé selon la revendication 5, caractérisé en ce que chaque groupe (O, $P_1$, $P_2$, $P_3$) est constitué d'une ou de plusieurs lentilles optoélectroniques.

7. Procédé selon la revendication 1 ou 6, caractérisé en ce qu'un système de déviation est disposé dans le plan de croisement d'entrée ($C_E'$) pour aligner la direction du faisceau électronique issu du premier étage de reproduction (14) sur l'axe (24) du spectromètre (15).

8. Procédé selon une des revendications 1 à 7, caractérisé en ce qu'un diaphragme d'ouverture (42) adjustable, présentant des ouvertures circulaires (42a, 42b) interchangeables, est disposé entre le point de croisement d'entrée ($C_E$) et le plan d'image d'entrée ($B_E$) du spectromètre (15).

9. Procédé selon une des revendications 1 à 8, caractérisé en ce qu'un diaphragme à fente (43) de largeur variable est disposé dans le plan de dispersion ($C_A$) du spectromètre (15), diaphragme qui est constitué de deux mâchoires (43b, 43c) de délimitation de la fente, qui sont isolées l'une par rapport à l'autre et par rapport au corps (43a) et auxquelles sont amenées, à travers le corps (43a), des lignes de mesure (43d, 43e) séparées.

10. Procédé selon une des revendications 1 à 9, caractérisé en ce que le spectromètre formateur d'images (15) à énergie électronique est un système à prismemiroir-prisme dont les prismes (20) présentent des faces d'entrée et de sortie (51, 52, 53) non planes, ayant des rayons de courbure $R_1$ et $R_2$ constants dont les valeurs sont comprises dans les plages suivantes

$$1{,}0 < R_1/R < 1{,}35$$

$$0{,}8 < R_2/R < 1{,}8$$

lorsque l'angle ε entre l'axe optique (24) du faisceau électronique incident (25) et la normale (54) à la face d'entrée (51) au point d'entrée (55) est compris dans la plage

$$40° < ε < 55°$$

et lorsque le quotient de la longueur focale d'entrée du spectromètre ($f_1$) et le rayon (R) des trajectoires en partie de cercle dans le spectromètre correspond à

$f_1/R \geqslant 1,8.$

## Claims

1. A method for electron energy-filtered imaging of an object with a transmission electron microscope, in which the electron beams emitted by an electron source illuminate the object, in which the object is imaged from a first imaging stage into the input image plane of an image-forming electron energy spectrometer, and in which at the same time the electron source is imaged in the input crossover point of the spectrometer, in which further the electrons of a preselected energy range are filtered out in the spectrometer and the filtered object image is imaged from the output image plane of the spectrometer through a second imaging stage into the final image plane, characterized by the fact that the first imaging stage (14) produces four intermediate images (B1, B2, B3, B4) of the object (13), with the fourth intermediate image (B4) always lying in the input image plane (BE) of the spectrometer (15), and with the second intermediate image being either real (B2) or virtual (B2*) while all other intermediate images (B1, B3, B4) are always real, and that the first imaging stage (14) simultaneously produces four intermediate images (crossover) (C1, C2, C3, C4) of the electron source (11), with the fourth crossover (C4) always lying in the input crossover point (CE) of the spectrometer (15), and with the third crossover being either real (C3) or virtual (C3*), while all other crossovers (C1, C2, C4) are always real.

2. A method for electron energy-filtered imaging of an object with a transmission electron microscope, in which the electron beams emitted by an electron source illuminate the object, in which the object is imaged from a first imaging stage into the input image plane of an image-forming electron energy spectrometer, and in which at the same time the electron source is imaged in the input crossover point of the spectrometer, in which further the electrons of a preselected energy range are filtered out in the spectrometer and the filtered object image is imaged from the output image plane of the spectrometer through a second imaging stage into the final image plane, characterized by the fact that the first imaging stage (14) produces four intermediate images (B1, B2, B3, B4) of the object (13), with the fourth intermediate image (B4) always lying in the input image plane (BE) of the spectrometer (15), and with the first intermediate image (B1*) always being virtual and the second to fourth intermediate images (B2, B3, B4) always being real, and that the first imaging stage (14) simultaneously produces four intermediate images (crossover) (C1, C2, C3, C4) of the electron source (11), with the fourth crossover (C4) always lying in the input crossover point (CE) of the spectrometer (15), and with the second crossover being always vitual (C2*), while the third and fourth crossovers (C3, C4) are always real.

3. A method for electron energy-filtered imaging of the diffraction diagram of an object with a transmission electron microscope, in which the electron beams emitted by an electron source illuminate the object, a first imaging stage produces the diffraction diagram of the object and images the diagram in the input image plane of an image-forming electron energy spectrometer, with the object being imaged simultaneously in the input crossover point of the spectrometer, in which further the electrons of a preselected energy range are filtered out in the spectrometer and the filtered image of the diffraction diagram of the object is imaged from the output image plane of said spectrometer through a second imaging stage into the final image plane (17), characterized by the fact that the first imaging stage (14) produces the diffraction diagram (C1') of the object (13) and three intermediate images (C2', C3', C4') of the diffraction diagram, with the third intermediate image (C4') always lying in the input image plane (BE) of the spectrometer (15), and with all intermediate images being real, and that the first imaging stage (14) simultaneously produces four intermediate images (B1', B2'*, B3', B4') of the object, with the fourth intermediate image (B4') always lying in the input crossover plane (CE') of the spectrometer (15), and with the second intermediate image always being vitual, while all other intermediate images (B1', B3', B4') are always real.

4. A method according to claims 1 to 3, characterized by the fact that with the second imaging stage (16) the output image plane (BA) of the spectrometer (15) is imaged with a constant magnification in the final image plane (17), with the constant magnification only being adapted to the image-limiting surface of the respective detector (17a, 17b, 17c).

5. A method according to claims 1 to 4, characterized by the fact that the first imaging stage (14) consists of four electron-optical lens groups (O, P1, P2, P3) each connected to a power supply unit (41), in which the required exciting current is fixed for each magnification stage and for each lens.

6. A method according to claim 5, characterized by the fact that each lens group (O, P1, P2, P3) comprises one or several electron optical lenses.

7. A method according to claims 1 to 6, characterized by the fact that a deflection system is located in the input crossover plane (CE') by which the direction of the electron beam bundle emitted from the first imaging stage (14) can be aligned with respect to the axis (24) of the spectrometer (15).

8. A method according to claims 1 to 7, characterized by the fact that an adjustable aperture diaphragm (42) with changeable annular openings (42a, 42b) is located between the input crossover point (CE) and the input image plane (BE) of the spectrometer (15).

9. A method according to claims 1 to 4, characterized by the fact that a slit diaphragm (43) of adjustable width is located in the dispersion plane (CA) of the spectrometer (15); said diaphragm consisting of two slit jaws (43b, 43c) isolated with respect to each other and to the housing (43a), with discrete measuring lines (43d, 43e) leading to each of said jaws through the housing (43a).

10. A method according to claims 1 to 9, characterized by the fact that the imaging electron-energy spectrometer (15) is a prism-mirror-prism system with the prisms (20) having nonplanar entrance and exit surfaces (51, 52, 53) with the constand curvature radii R1 and R2 ranging between

$$1.0 < R_1/R < 1.35$$

$$0.8 < R_2/R < 1.8$$

if the range

$$40° < \varepsilon < 55°$$

applies for the angle $\varepsilon$ between the optical axis (24) of the incident electron beam (25) and the normal (54) in the entrance point (55) on the entrance surface (51), and

$$f_1/R \geq 1.8$$

applies for the quotient of the input focal length of the spectrometer (f1) and the radius of the circular orbits inside the spectrometer (R).

Fig.1

EP 0 166 328 B1

Fig. 2

# Fig. 3a

# Fig. 3b

# Fig. 3c

# Fig. 3d

# Fig. 4

Fig.5